# EUROPÄISCHE PATENTANMELDUNG

(11) **EP 2 886 244 A1**
(43) Veröffentlichungstag der Anmeldung: **24.06.2015**
(21) Anmeldenummer: 13197640.9
(22) Anmeldetag: 17.12.2013
(51) Int. Cl.: B23K 35/26, B23K 35/36, B23K 35/02, H05K 3/34

(54) **Verfahren zur Befestigung eines Bauteils auf einem Substrat**

(71) Anmelder: Heraeus Deutschland GmbH & Co. KG, 63450 Hanau (DE)
(72) Erfinder: Nachreiner, Jens, 36381 Schlüchtern (DE); Wiese, Joachim, Dr., 64739 Höchst (DE); Fritzsche, Sebastian, Dr., 63454 Hanau (DE)
(74) Vertreter: Heraeus IP

(57) **Zusammenfassung**

Die vorliegende Erfindung betrifft ein Verfahren zur Befestigung eines elektronischen Bauteils auf einem Substrat, unter Verwendung einer Lotpaste, die eine Mischung aus organischen Dicarbonsäuren umfasst und bei welchem die Dicke des Lotdepots 25 bis 200 µm beträgt.

## Beschreibung

Die vorliegende Erfindung betrifft ein Verfahren zur Befestigung eines elektronischen Bauteils auf einem Substrat, unter Verwendung einer Lotpaste, die eine Mischung aus organischen Dicarbonsäuren umfasst und bei welchem die Dicke des Lotdepots 25 bis 200 µm beträgt.

Lotpasten, vor allem Weichlotpasten, finden vor allem in der Fertigung integraler Schaltkreise, wie beispielsweise in der Halbleiterindustrie, Verwendung. Dabei werden elektronische Bauteile auf Substrate, wie beispielsweise Leiterplatten, aufgebracht und mit Hilfe einer Lotpaste mechanisch, elektronisch und thermisch mit diesen verbunden. Folglich sind die Anforderungen, die an ein solches Verfahren und die darin eingesetzten Lotpasten gestellt werden, mannigfaltig, vor allem unter Berücksichtigung eines automatisierten Prozesses. In der Regel wird die Oberfläche des Substrats mit einer Lotpaste versehen, über die der Kontakt mit dem Bauteil hergestellt wird. Durch Erwärmen der Lotpaste kommt es zur Festigung des mechanischen Kontaktes. Neben der mechanischen Haftung kann die Lotpaste auch dazu dienen einen elektrischen Kontakt zwischen Bauteil und Substrat herzustellen und/oder die während des Betriebs des Bauteils entstehende Wärme abzuleiten. WO 02/20211 A1 beschreibt ein Lötmittel zur Verwendung bei Diffusionslötprozessen, das eine Mischung aus mindestens teilweise metallisierten Körnern aus einem hochschmelzenden Metall und einem Lotmetall umfasst, die sich durch ihre Schmelztemperatur unterscheiden.

DE 195 11 392 A1 beschreibt ein Verfahren und eine Vorrichtung zum Aufbringen von Löthöckern mittels energiereicher Strahlung, insbesondere Laserstrahlung.

US 5,672,542 betrifft ein Verfahren und einen Prozess für das Aufbringen von elektrisch leitenden Substanzen auf ein Substrat mit Hilfe von Lötkugeln, wobei die Lötkugeln einen Abstand von maximal 400 µm zueinander haben.

Eine besondere Herausforderung stellen bei diesen Verfahren elektronische Bauteile dar, die neben elektrischen Anschlussstellen auch über thermische Anschlussstellen auf der Unterseite verfügen, wie beispielsweise QFP-Bauteile (Quad Flat Package), die über elektrische Anschlussstellen in Form sogenannter Beinchen, die an den Seiten des Bauteils angebracht sind und über die der elektrische Kontakt zwischen Bauteil und Substrat hergestellt wird, verfügen, sowie eine thermische Anschlussstelle auf der Unterseite aufweisen, die dazu dient, die während des Betriebs generierte Wärme des Bauteils abzuleiten. Die Kontaktierung der Anschlussstellen mit dem Substrat erfolgt jeweils mit Hilfe von unterschiedlichen Lotpasten, eine für die thermische und eine für die elektrische Verbindung. Dabei kann es vorkommen, dass das eingebrachte Lotdepot der thermischen Anschlussstellen beim Erwärmen verläuft. Dabei werden Lotpulverpartikel, meist in Form sogenannter Lotkugeln, in Richtung der elektrischen Anschlussstellen ausgetrieben und können dort zu Kurzschlüssen führen. Dies wird vor allem dann problematisch, wenn aufgrund des vorgegebenen Abstandes zwischen Bauteil und Substrat, beispielsweise über die elektrischen Anschlussstellen, entsprechend viel der Lotpaste verwendet werden muss, damit es zu einer beiderseitigen Kontaktierung kommt.

Es ist somit Aufgabe der vorliegenden Erfindung ein Verfahren zur Befestigung von Bauteilen, insbesondere Bauteilen mit elektrischen und thermischen Anschlussstellen, auf Substraten bereitzustellen, bei dem ein Ausfließen der Lotpaste und die Entstehung unerwünschter Lotkugeln verhindert wird, so dass das Auftreten von elektrischen Kurzschlüssen verhindert, wenigstens aber minimiert wird, ohne die thermische und mechanische Verbindung des Bauteils an das Substrat zu beeinträchtigen.

Unter Ausfließen im Rahmen der vorliegenden Erfindung ist das Zerlaufen der Lotpaste für die thermische Verbindung zwischen Bauteil und Substrat über die Abgrenzungen der thermischen Anschlussstelle des Bauteils und/oder Substrates hinaus sowie die Entstehung unerwünschter Lotkugeln, wenn die Lotpaste unter Prozessbedingungen erwärmt wird, so dass es zu einem Kontakt zwischen der Lotpaste und den elektrischen Anschlussstellen des Bauteils und damit zu Kurzschlüssen kommt, zu verstehen.

Die Aufgabe wird durch die Gegenstände der unabhängigen Ansprüche der vorliegenden Erfindung gelöst.

Es wurde überraschend gefunden, dass durch die Verwendung einer Lotpaste, die ein Lot und ein Flussmittel, insbesondere ein Flussmittel, das eine Mischung aus zwei verschiedenen Dicarbonsäuren aufweist, umfasst, das Ausfließen der Lotpaste und die Entstehung unerwünschter Lotkugeln, und damit von Kurzschlüssen an den elektrischen Anschlussstellen des Bauteils, verhindert werden können. Zudem wurde auch gefunden, dass die Dicke des Lotdepots zwischen Bauteil und Substrat entscheidend das Ausfließen steuert.

Daher ist ein Gegenstand der vorliegenden Erfindung ein Verfahren zur Befestigung eines Bauteils auf einem Substrat, das die folgenden Schritte umfasst:
i) Bereitstellen eines Bauteils mit einer ersten Oberfläche, wobei das Bauteil mit elektrischen und thermischen Anschlussstellen versehen ist;
ii) Bereitstellen eines Substrates mit einer zweiten Oberfläche, die mit einem Lotdepot versehen ist;
iii) Mechanisches Kontaktieren der ersten Oberfläche des Bauteils mit der zweiten Oberfläche des Substrates über das Lotdepot, wobei die Dicke des Lotdepots 25 bis 200 µm beträgt; und
iv) Erhitzen des Lotdepots über die Liquidustemperatur des Lots,
   wobei das Lotdepot durch eine Lotpaste, umfassend ein Lot und ein Flussmittel, wobei das Flussmittel eine Dicarbonsäure A und eine Dicarbonsäure B, die voneinander verschieden sind, aufweist, gebildet wird.

Ein wesentlicher Bestandteil des Verfahrens ist das Lotdepot, das im Folgenden näher beschrieben wird.

### a) Lotdepot

Das Lotdepot wird aus einer Lotpaste gebildet, die sich aus einem Flussmittel und einem Lot zusammensetzt. Die einzelnen Komponenten der Lotpaste sind im Folgenden näher ausgeführt.

### Flussmittel:

Das Flussmittel ist ein wichtiger Bestandteil der Lotpaste und bestimmt vor allem deren rheologische Eigenschaften. Es wurde überraschend gefunden, dass das Auftreten von Kurzschlüssen bei der Befestigung eines Bauteils auf einem Substrat verringert werden kann, wenn ein Flussmittel verwendet wird, das eine Mischung aus zwei verschiedenen Dicarbonsäuren aufweist. Es hat sich gezeigt, dass durch die Verwendung einer Lotpaste, welche besagtes Flussmittel aufweist, eine stabile mechanische und thermische Verbindung zwischen Bauteil und Substrat ausgebildet wird, ohne dass elektrische Kurzschlüsse auftreten, und dass die Lotpaste gleichzeitig eine gute Verarbeitbarkeit und gute Benetzungseigenschaften aufweist. Insbesondere im Zusammenspiel der Lotpaste mit einer definierten Depotdicke im Bereich von 25 bis 200 µm, zeigen sich hervorragende Eigenschaften.

Besonders gute Ergebnisse wurden mit Dicarbonsäuren erzielt, die eine bestimmte Anzahl von Kohlenstoffatomen aufwiesen.

Daher ist eine Ausführungsform des erfindungsgemäßen Verfahrens bevorzugt, bei der Dicarbonsäure A 5 oder mehr Kohlenstoffatome, vorzugsweise 6 bis 8 Kohlenstoffatome und insbesondere 6 Kohlenstoffatome aufweist. In einer besonders bevorzugten Ausführungsform ist Dicarbonsäure A Adipinsäure.

Weiterhin hat es sich als vorteilhaft erwiesen, wenn als weitere Komponente eine Dicarbonsäure B verwendet wird, die weniger Kohlenstoffatome als Dicarbonsäure A aufweist.

Folglich ist weiterhin eine Ausführungsform bevorzugt, in der Dicarbonsäure B 4 oder weniger Kohlenstoffatome, insbesondere 2 Kohlenstoffatome, aufweist. Besonders bevorzugt ist eine Ausführungsform in der Dicarbonsäure B Oxalsäure ist. Es wurde weiterhin überraschend gefunden, dass die vorteilhaften Effekte insbesondere dann auftreten, wenn Dicarbonsäure A und Dicarbonsäure B in einem bestimmten Gewichtsverhältnis zueinander vorliegen.

In einer bevorzugten Ausführungsform beträgt das Gewichtsverhältnis von Dicarbonsäure A zu Dicarbonsäure B daher 30:1 bis 5:1, vorzugsweise 25:1 bis 7:1, insbesondere 20:1 bis 10:1.

In einer besonders bevorzugten Ausführungsform des erfindungsgemäßen Verfahrens umfasst die Lotpaste die folgenden Komponenten:
a) 5 bis 15 Gew.-% eines Flussmittels und
b) 85 bis 95 Gew.-% eines Lots,
wobei sich die Gewichtsangaben jeweils auf das Gesamtgewicht der Lotpaste beziehen und wobei das Flussmittel
i) 7 bis 13 Gew.-% Dicarbonsäure A, vorzugsweise Adipinsäure;
ii) 0,3 bis 2,0 Gew.-% Dicarbonsäure B, vorzugsweise Oxalsäure; und
iii) Amin, vorzugsweise ausgewählt aus Aminkomponente X und Aminkomponente Y, wobei Aminkomponente X ein Diamin mit tertiären Aminogruppen ist; und Aminkomponente Y ein Diamin oder Polyamin ist, bei denen wenigstens 2 der Aminogruppen durch mindestens 3 Kohlenstoffatome voneinander getrennt sind und die wenigstens 4 Kohlenstoffatome aufweisen, umfasst,
   wobei sich die Gewichtsangaben der Dicarbonsäuren jeweils auf das Gesamtgewicht des Flussmittels beziehen.

Besonders bevorzugt ist eine Ausführungsform in der das Flussmittel Dicarbonsäure A in einer Menge von 7 bis 13 Gew.-%, vorzugsweise 8 bis 12 Gew.-%, jeweils bezogen auf das Gesamtgewicht des Flussmittels, aufweist.

Weiterhin bevorzugt ist eine Ausführungsform, in der das Flussmittel Dicarbonsäure B in einer Menge von 0,3 bis 2,0 Gew.-%, vorzugsweise von 0,4 bis 1,5 Gew.-%, weiter bevorzugt von 0,45 bis 1,0 Gew.-%, jeweils bezogen auf das Gesamtgewicht des Flussmittels, aufweist.

Im Folgenden werden die Aminkomponenten X und Y näher erläutert.

### Aminkomponente X

Aminkomponente X ist ein Diamin, welches wenigstens eine tertiäre Aminogruppe, bevorzugt zwei tertiäre Aminogruppen aufweist.

Es ist eine Ausführungsform bevorzugt, in der Aminkomponente X ausgewählt ist aus der Gruppe bestehend aus 1,2-Tetramethylethylendiamin, 1,2-Tetraethylethylendiamin und 1,2-Tetrapropylethylendiamin, beispielsweise 1,2-Tetra-n-propylethylendiamin und 1,2-Tetra-iso-propylethylendiamin. Insbesondere bevorzugt sind solche Diamine, bei denen jede tertiäre Aminogruppe zwei identische Substituenten aufweist.

Tertiäres Amin im Sinne der vorliegenden Erfindung ist ein Amin, dessen Stickstoffatom drei kohlenstoffhaltige Substituenten trägt.

### Aminkomponente Y

Aminkomponente Y ist ein Diamin oder Polyamin, bei denen wenigstens 2 der Aminogruppen durch mindestens 3 Kohlenstoffatome voneinander getrennt sind und die wenigstens 4 Kohlenstoffatome aufweisen.

Aminkomponente Y ist ein Diamin, bei dem die beiden Aminogruppen durch mindestens 3 Kohlenstoffatome voneinander getrennt sind und das wenigstens 4 Kohlenstoffatome aufweist. Alternativ ist Aminkomponente Y ein Polyamin, bei dem wenigstens 2 der Aminogruppen durch mindestens 3 Kohlenstoffatome voneinander getrennt sind und das wenigstens 4 Kohlenstoffatome aufweist.

Es hat sich weiterhin überraschend gezeigt, dass sich die vorteilhaften rheologischen Eigenschaften der Lotpaste weiter verbessern lassen, wenn Aminkomponente Y eine primäre Aminogruppe aufweist.

In einer bevorzugten Ausführungsform der vorliegenden Erfindung weist Aminkomponente Y daher mindestens eine primäre Aminogruppe auf.

Bevorzugt ist eine Ausführungsform in der Aminkomponente Y ausgewählt ist aus der Gruppe bestehend aus N-Coco-1,3-diaminopropan, 1,6-Diaminohexan, 1,7-Diaminoheptan, 1,8-Diaminooktan, 1,9-Diaminononan und 1,10-Diaminodecan.

In einer weiter bevorzugten Ausführungsform weist das einzusetzende Amin, das heißt Aminkomponente X oder Aminkomponente Y, keine tertiären und/oder quaternären Kohlenstoffatome auf.

Weiterhin bevorzugt ist eine Ausführungsform, in der das Amin mindestens 6 Kohlenstoffatome aufweist. Dabei können die Kohlenstoffatome als Verbindungskette zwischen zwei Aminogruppen vorliegen oder als Substituenten der Stickstoffatome an diese gebunden sein.

In einer bevorzugten Ausführungsform beträgt die Gesamtmenge an Amin, also Aminkomponente A und/oder Aminkomponente B im Flussmittel 2 Gew.-% oder weniger, vorzugsweise 1 Gew.-% oder weniger, beispielsweise 0,1 Gew.-% bis 2,0 Gew.-%, jeweils bezogen auf das Gesamtgewicht des Flussmittels.

Die Menge an Amin im Flussmittel ist vorzugsweise so gewählt, dass eine gute Verarbeitbarkeit der Lotpaste sowie eine gute Benetzung der Oberflächen des zu befestigenden Bauteils und des Substrates gewährleistet sind.

Daher ist eine Ausführungsform bevorzugt, in der das Flussmittel Aminkomponente X und/oder Aminkomponente Y in einer Menge von 0,1 bis 2,0 Gew.-%, vorzugsweise von 0,4 bis 1,0 Gew.-%, jeweils bezogen auf das Gesamtgewicht des Flussmittels, aufweist.

In einer weiter bevorzugten Ausführungsform weist das Flussmittel zusätzlich Monoamin auf. Das Monoamin liegt zusätzlich zu der Aminkomponente X und/oder der Aminkomponente Y vor.

Besonders gute Ergebnisse, vor allem hinsichtlich der Verarbeitbarkeit und des Ausfließverhaltens der Lotpaste, können erzielt werden, wenn es sich bei dem Monoamin um ein sekundäres und/oder tertiäres Monoamin handelt. Daher ist eine Ausführungsform bevorzugt, in der das Monoamin ausgewählt ist aus der Gruppe bestehend aus sekundärem Monoamin und tertiärem Monoamin sowie Mischungen davon. Besonders bevorzugt ist das Monoamin ein tertiäres Monoamin. Vorzugsweise umfasst das Flussmittel Monoamin in einer Menge von 0,5 bis 5,5 Gew.-%, vorzugsweise von 1,0 bis 5,0 Gew.-%, jeweils bezogen auf das Gesamtgewicht des Flussmittels.

Als besonders vorteilhaft hat es sich erwiesen, wenn das Flussmittel neben den Dicarbonsäuren A und B weitere Dicarbonsäuren aufweist, die von den Dicarbonsäuren A und B verschieden sind.

Daher ist eine Ausführungsform bevorzugt, in der das Flussmittel zusätzlich Dicarbonsäuren, die von Dicarbonsäure A und Dicarbonsäure B verschieden sind, in einer Menge von 0 bis 2 Gew.-%, vorzugsweise in einer Menge von 0,01 bis 1,0 Gew.-%, jeweils bezogen auf das Gesamtgewicht des Flussmittels, aufweist. Weiterhin bevorzugt ist eine Ausführungsform, in der die Gesamtmenge aller Dicarbonsäuren im Flussmittel maximal 15 Gew.-%, vorzugsweise 7 bis 13 Gew.-%, insbesondere 8 bis 12 Gew.-%, jeweils bezogen auf das Gesamtgewicht des Flussmittels, beträgt.

Es hat sich gezeigt, dass die Benetzungseigenschaften und die Verarbeitbarkeit sowie weitere Eigenschaften der Lotpaste mit Hilfe weiterer Additive verbessert werden können.

Daher umfasst das Flussmittel der Lotpaste zur Verwendung im erfindungsgemäßen Verfahren weitere Additive, vorzugsweise in einer Menge von 0,05 bis 3,0 Gew.-%, jeweils bezogen auf das Gesamtgewicht des Flussmittels. Bei diesen Additiven handelt es sich vorzugsweise um Verbindungen, die die Benetzungseigenschaften der Lotpaste verbessern, wie zum Beispiel ethoxyliertes Aminharz, Aminharz, Methylester von Harzen, n-Oleylsarcosin, Oleylimidazolin sowie Mischungen davon. Bevorzugt ist eine Ausführungsform, in der das Flussmittel weiterhin zusätzlich ein Lösungsmittel umfasst, insbesondere ein Lösungsmittel, ausgewählt aus der Gruppe bestehend aus bei 25 °C flüssige Diole, Alkohole, Etheralkohole und Ketone, insbesondere Trimethylpropanol, 1,2-Oktandiol, 1,8-Oktandiol, 2,5-Dimethyl-2,5-hexandiol, iso-Bornylcyclohexanon, Glykolether, 2-Ethyl-1,3-hexandiol, n-Decylalkohol, 2-Methyl-2,4-pentandiol, Terpineol und Isopropanol sowie Mischungen davon. In einer weiteren bevorzugten Ausführungsform ist der Glykolether ausgewählt aus der Gruppe bestehend aus Mono-, Di-, Tri-Propylenglykolmethylether, Mono-, Di-, Tri-Propylenglykol-n-butylether, Mono-, Di-, Tri-Ethylenglykol-n-butylether, Ethylenglykolmethylether, Triethylenglykolmethylether, Diethylenglykoldibutylether, Tetraethylenglykoldimethylether und Diethylenglykol-monohexylether sowie Mischungen davon.

Weiterhin kann das Flussmittel ein Harz aufweisen, um der Lotpaste die für die jeweilige Verwendung benötigte Konsistenz zu verleihen. In einer bevorzugten Ausführungsform weist das Flussmittel zusätzlich ein Harz auf, bevorzugt ein Harz ausgewählt aus der Gruppe bestehend aus Kolophonium, Tallöl, hydriertes Kolophonium, dimerisiertes Kolophonium, teilweise dimerisiertes Kolophonium und Mischungen davon.

In einer bevorzugten Ausführungsform liegt das Harz in einer Menge von 35 bis 50 Gew.-%, bevorzugt 40 bis 48 Gew.-%, jeweils bezogen auf das Gesamtgewicht des Flussmittels, vor.

Die Ergebnisse des erfindungsgemäßen Verfahrens lassen sich weiter verbessern, wenn das Flussmittel einen Aktivator, beispielsweise eine halogenhaltige Verbindung, aufweist, der die Oberflächen des Lotpulvers, des zu verbindenden Bauteils und des Substrates aktiviert und so für eine bessere Verbindung der Komponenten sorgt.

Daher ist eine Ausführungsform bevorzugt, in der das Flussmittel zusätzlich halogenhaltige Verbindungen ausgewählt aus der Gruppe bestehend aus Anilinhydrochlorid, Glutaminsäurehydrochlorid, Diethanolaminhydrochlorid, Diethanolaminhydrobromid, Triethanolaminhydrochlorid, Triethanolamin-hydrobromid und trans-2,3-Dibrom-2-buten-1,4-diol sowie Mischungen davon umfasst.

Als besonders vorteilhaft hat es sich erwiesen, wenn die Menge an halogenhaltigen Verbindungen im Flussmittel 5 Gew.-%, bezogen auf das Gesamtgewicht des Flussmittels, nicht überschreitet. Daher ist eine Ausführungsform der erfindungsgemäßen Lotpaste bevorzugt, in der das Flussmittel halogenhaltige Verbindungen in einer Menge von 0,1 bis 3,0 Gew.-%, vorzugsweise 0,5 bis 2,0 Gew.-%, jeweils bezogen auf das Gesamtgewicht des Flussmittels, umfasst.

In einer alternativ bevorzugten Ausführungsform ist die Lotpaste, die in dem erfindungsgemäßen Verfahren eingesetzt wird, im Wesentlichen frei von halogenhaltigen Verbindungen. Als im Wesentlichen frei von halogenhaltigen Verbindungen im Rahmen der vorliegenden Erfindung sind Pasten anzusehen, die halogenhaltige Verbindungen in einer Menge von weniger als 0,1 Gew.-%, vorzugsweise zwischen 0 und 0,09 Gew.-%, speziell weniger als 0,01 Gew.-% oder weniger als 0,005 Gew.-%, jeweils bezogen auf das Gesamtgewicht des Flussmittels, aufweisen.

Zur Verbesserung der rheologischen Eigenschaften und der Benetzbarkeit der Lotpaste kann das Flussmittel beispielsweise Verdickungsmittel enthalten. In einer bevorzugten Ausführungsform umfasst das Flussmittel zusätzlich ein oder mehrere Verdickungsmittel, bevorzugt ausgewählt aus der Gruppe bestehend aus Ethylcellulose, hydriertes Rizinusöl, Glycerin-tris-12-hydroxystearin und modifiziertes Glycerin-tris-12-hydroxystearin. Vorzugsweise weist das Flussmittel Verdickungsmittel in einer Menge von 1,0 bis 4,0 Gew.-%, bevorzugt von 1,7 bis 3,0 Gew.-%, jeweils bezogen auf das Gesamtgewicht des Flussmittels, auf.

Ein weiterer wichtiger Bestandteil der Lotpaste, die in dem erfindungsgemäßen Verfahren eingesetzt wird, ist das Lot, das im Folgenden näher beschrieben wird.

### Lot:

Das Lot bildet zusammen mit dem Flussmittel das Lotdepot, über das die thermische Anbindung des Bauteils an das Substrat erfolgt. Da über diese Verbindung die Wärme, die während des Betriebs des Bauteils generiert wird, abgeleitet werden soll, ist es wünschenswert, dass das Lot eine gute Wärmeleitfähigkeit besitzt, möglichst in Verbindung mit einer begrenzten elektrischen Leitfähigkeit. Diese Eigenschaften finden sich vor allem in Loten, die Zinn als Hauptbestandteil aufweisen.

Daher ist eine Ausführungsform bevorzugt, in der das Lot ein Lot auf Zinnbasis ist.

Ein Lot auf Zinnbasis im Rahmen der vorliegenden Erfindung beschreibt ein Lot, das mindestens 80 Gew.-%, vorzugsweise mindestens 83 Gew.-%, insbesondere zwischen 85 und 90 Gew.-%, Zinn aufweist, wobei sich die Gewichtsangaben jeweils auf die Gesamtmenge des Lot beziehen.

In einer bevorzugten Ausführungsform kann das Lot neben Zinn weitere Metalle umfassen, um beispielsweise die Liquidustemperatur des Lots auf einen für die jeweilige Anwendung vorteilhaften Bereich einzustellen.

Daher ist eine Ausführungsform bevorzugt, in der das Lot Silber in einer Menge von 0,1 bis 8 Gew.-%, vorzugsweise 0,2 bis 6 Gew.-%, jeweils bezogen auf das Gesamtgewicht des Lots, umfasst.

In einer weiter bevorzugten Ausführungsform umfasst das Lot Kupfer in einer Menge von 0,1 bis 1,5 Gew.-%, vorzugsweise 0,2 bis 1,0 Gew.-%, jeweils bezogen auf das Gesamtgewicht des Lots.

Weiterhin bevorzugt ist eine Ausführungsform, in der das Lot bleifrei ist.

Die Lotpaste eignet sich vor allem für den Einsatz in dem erfindungsgemäßen Verfahren, bei denen das Lot über seine Liquidustemperatur erwärmt wird und so für eine optimale Verbindung zwischen Bauteil und Substrat sorgt. Aus energietechnischen Gesichtspunkten und unter Berücksichtigung der empfindlichen Bauteile und Substrate, sollte daher die Liquidustemperatur des Lots nicht zu hoch sein.

Daher ist eine Ausführungsform bevorzugt, in der das Lot eine Liquidustemperatur in einem Bereich von 200 bis 250 °C, vorzugsweise in einem Bereich von 200 bis 230 °C, aufweist.

In einer bevorzugten Ausführungsform liegt das Lot in Pulverform vor, vorzugsweise mit einer gewichtmittleren Teilchengröße von 15 bis 50 µm, vorzugsweise von 20 bis 45 µm, bestimmt gemäß IPC-TM-650 2.2.14-2.2.14.2. In einer bevorzugten Ausführungsform weisen 80 bis 90% der Teilchen im Pulver eine Größe in dem Bereich von 15 bis 50 µm, vorzugsweise von 20 bis 45 µm auf. Teilchengröße im Rahmen der vorliegenden Erfindung bezeichnet die maximale lineare Ausdehnung eines Teilchens.

In einer weiterhin bevorzugten Ausführungsform umfasst die Lotpaste das Lot in einer Menge von 80 bis 97 Gew.-%, vorzugsweise 83 bis 95 Gew.-%, insbesondere 85 bis 93 Gew.-%, jeweils bezogen auf das Gesamtgewicht der Lotpaste.

### b) Verfahren

Im Folgenden werden die einzelnen Schritte des erfindungsgemäßen Verfahrens näher erläutert.

In einem ersten Schritt des erfindungsgemäßen Verfahrens zur Befestigung eines Bauteils auf einem Substrat wird ein Bauteil bereitgestellt. Das erfindungsgemäße Verfahren ist vor allem für das Befestigen von Bauteilen, die über thermische und elektrische Anschlussstellen verfügen, auf Substraten geeignet, wobei die Kontaktierung über eine erste Oberfläche des Bauteils und eine zweite Oberfläche des Substrates mit Hilfe eines Lotdepots erfolgt. Vorzugsweise umfasst die erste Oberfläche des Bauteils mindestens ein Metall, das ausgewählt ist aus der Gruppe bestehend aus Kupfer, Silber, Gold, Nickel, Aluminium, Zinn, Palladium sowie Legierungen von zwei oder mehreren der genannten Metalle.

Vorzugsweise weist das Bauteil eine quadratische Grundfläche auf. Besonders bevorzugt liegt diese in einem Bereich von 3 x 3 bis 100 x 100 mm, vorzugsweise von 5 x 5 bis 80 x 80 mm.

In einer weiterhin bevorzugten Ausführungsform ist das Bauteil ausgewählt aus der Gruppe der Quad Flat Packages (QFP), beispielsweise Bumpered Quad Flat Package mit Hitzeverteiler (BQFPH) und Heat sinked Quad Flat Package (HQFP).

In einem zweiten Schritt wird ein Substrat bereitgestellt, das mit einem Lotdepot versehen ist. Das Substrat, auf dem das Bauteil mit Hilfe des erfindungsgemäßen Verfahrens befestigt wird, weist eine zweite Oberfläche auf, über die die Kontaktierung mit dem Bauteil erfolgt. Vorzugsweise umfasst die zweite Oberfläche des Substrates mindestens ein Material, das ausgewählt ist aus der Gruppe bestehend aus Nickel, Kupfer, Gold, Silber, Aluminium, Zinn und Palladium sowie Legierungen von zwei oder mehrerer der genannten Metalle.

Vorzugsweise handelt es sich bei dem Substrat um ein metallisiertes Substrat, also um ein Substrat, das mindestens eine Metalloberfläche aufweist. Der Basiskörper des Substrates kann dabei beispielsweise aus Keramik, Papier, Epoxydharz oder reinem Kupfer bestehen.

Das erfindungsgemäße Verfahren eignet sich besonders für Prozesse, bei denen das Aufbringen des Lotdepots und das mechanische Kontaktieren des Bauteils mit dem Lotdepot automatisiert erfolgen. Um ein schnelles und präzises Arbeiten zu ermöglichen, ist es wünschenswert, dass das Aufbringen des Lotdepots schnell und ohne zusätzliche Arbeitsschritte erfolgt. Daher ist eine Ausführungsform des Verfahrens bevorzugt, in der das Aufbringen des Lotdepots mittels Siebdruck, Rakeln, Schablonendruck, Dispensen oder Jetten erfolgt. Auf diese Weise wird ein präzises Aufbringen, das auch die Herstellung kleiner integrierter Schaltkreise erlaubt, ermöglicht. Die Dicke des Lotdepots beträgt dabei 25 bis 200 µm, vorzugsweise 30 bis 150 µm, beispielsweise 50 bis 150 µm oder 80 bis 150 µm. Alternativ kann die Dicke des Lotdepots auch 25 bis 130 µm, insbesondere 30 bis 120 µm oder 30 bis 100 µm betragen. Auf diese Weise ist eine optimale thermische Anbindung des Bauteils an das Substrat und damit eine optimale Kühlung des Bauteils gewährleistet. Gleichfalls kann das Ausfließen in diesem Dickenbereich mit der gewählten Lotpaste verringert bzw. vermieden werden.

In einem nächsten Schritt des erfindungsgemäßen Verfahrens wird die erste Oberfläche des Bauteils mit der zweiten Oberfläche des Substrates über das Lotdepot mechanisch in Kontakt gebracht.

Anschließend wird die Lotpaste über die Liquidustemperatur des Lots erwärmt, so dass es zu einer Verbindung zwischen Bauteil und Substrat über die Lotpaste kommt. Dabei wird die Lotpaste vorzugsweise so erwärmt, dass das Lot in seine Liquidusphase übergeht, jedoch ohne dass es zu einer Beschädigung der Lotpaste, des Bauteils und/oder des Substrates kommt. Das Lot wird vorzugsweise auf eine Temperatur erwärmt, die 5 bis 60 °C, vorzugsweise 10 bis 50 °C, über der Liquidustemperatur des Lots liegt. Das Erwärmen erfolgt vorzugsweise mit Hilfe einer Heizplatte, auf die das Substrat gelegt wird, so dass sich die Oberfläche des Substrates, die sich der zweiten Oberfläche gegenüber befindet, mit der Heizplatte in Kontakt steht. Alternativ kann das Erhitzen des Lots auch mit Hilfe beheizter Formteile, Bügel, Stempel, Infrarotstrahler, Laserstrahlen oder mit Hilfe von Dampf erfolgen.

Die gemäß dem erfindungsgemäßen Verfahren mit dem Substrat befestigten Bauteile weisen ein wesentlich verringertes Auftreten von Kurzschlüssen auf.

Ein weiterer Gegenstand der vorliegenden Erfindung ist daher ein Bauteil, welches auf einem Substrat befestigt ist und welches gemäß dem erfindungsgemäßen Verfahren erhältlich ist oder erhalten wird.

Die Erfindung soll anhand der folgenden Beispiele näher beschrieben werden, wobei diese jedoch nicht als Einschränkung des Erfindungsgedanken zu verstehen sind.

### Beispiele:

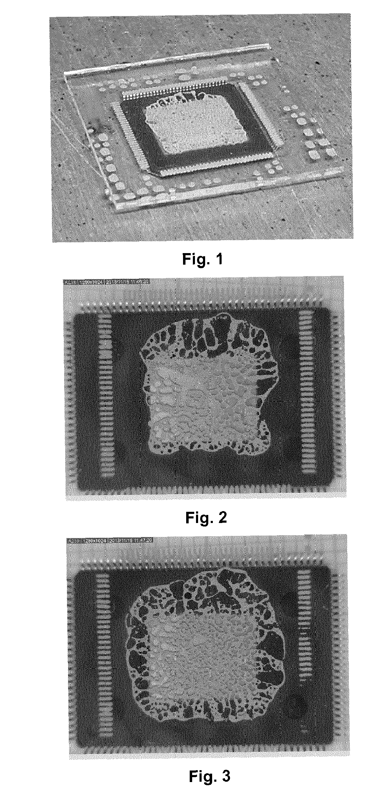

Die mit Hilfe des erfindungsgemäßen Verfahrens hergestellten Bauteile wurden anhand des Anti-Capillary-Tests (AC-Test) bei verschiedenen Dicken des Lotdepots beurteilt. Dazu wurde die Lotpaste auf die thermische Anschlussstelle eines QFP-Bauteils (beispielsweise von Infineon Technologies AG, Deutschland) aufgebracht und mit einer Glasplatte abgedeckt. Das QFP-Bauteil wurde mit der gegenüber liegenden Oberfläche auf eine Heizplatte mit einer Temperatur von 200 °C gelegt, so dass das Verhalten der Paste beurteilt werden konnte. Der Versuchsaufbau ist in Figur 1 dargestellt.

Die erhaltenen Ergebnisse wurden mittels Noten bewertet, wobei die Note 1 für sehr gute und die Note 2 für gute Ergebnisse steht, bei denen es zu keinen Kurzschlüssen aufgrund des unerwünschten Kontaktes der Lotpaste mit den elektrischen Anschlussstellen des Bauteils kam. Die Note 3 wurde für Tests vergeben, bei denen die Lotpaste so weit verlaufen ist, dass es zu einem Kontakt mit den elektrischen Anschlussstellen des Bauteils kam. Die Ergebnisse sind in Tabelle 2 zusammengefasst, wobei die Tests jeweils mit einer erfindungsgemäß einzusetzenden Lotpaste 1 und einer herkömmlichen Vergleichs-Lotpaste 2 durchgeführt wurden.

Tabelle 1 gibt die Rezeptur der verwendeten Lotpaste wieder, die in den AC-Tests eingesetzt wurden, wobei Lotpaste 1 eine erfindungsgemäß einzusetzende Lotpaste beschreibt, während Lotpaste 2 eine Lotpaste beschreibt, die nur eine Dicarbonsäure aufweist.

**Tabelle 1**

| Lotpaste | Lotpaste 1 | Lotpaste 2 |
|---|---|---|
| **Flussmittel** | Menge in Gew.-% | Menge in Gew.-% |
| Adipinsäure | 10,0 | 10,0 |
| Oxalsäure | 0,7 | - |
| Bis-C₈-dialkylamin | 2,1 | 2,1 |
| N,N-Dialkylfettamin | 2,1 | 2,1 |
| Hydriertes Kolophonium | 45,3 | 45,3 |
| Triethanolamin·HBr | 1,5 | 1,5 |
| Rizinusöl | 2,7 | 2,7 |
| Tri-Propylenglykol-n-butylether | 35,6 | 36,3 |
| Flussmittel (gesamt) | 100,0 | 100,0 |

| **Paste** | Menge in Gew.-% | Menge in Gew.-% |
|---|---|---|
| Lot (SnAgCu) | 89,25 | 89,25 |
| Flussmittel | ad 100,0 | ad 100 |

**Tabelle 2**

| Dicke Lotdepot | Lotpaste 1 (Ergebnis des AC-Tests) | Lotpaste 2 (Ergebnis des AC-Tests) |
|---|---|---|
| 100 µm | 1 | 3 |
| 120 µm | 1 | 3 |
| 160 µm | 2 | 3 |
| 240 µm | 3 | 3 |

Wie Tabelle 2 zu entnehmen, zeigt die erfindungsgemäße Lotpaste sehr gute bis gute Ergebnisse im AC-Test, während es bei Verwendung der herkömmlichen Vergleichs-Lotpaste 2 zu einem übermäßigen Verlaufen der Lotpaste und damit zu schlechten Ergebnissen im AC-Test kam.

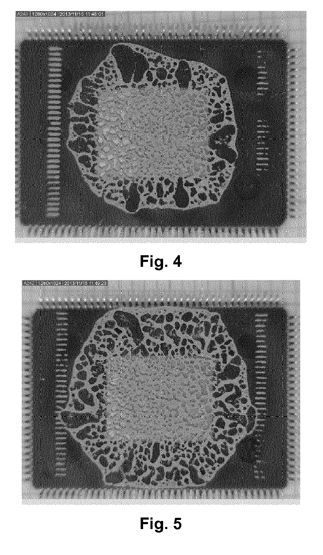

Die Figuren 2 bis 5 zeigen die Ergebnisse der AC-Tests unter Verwendung der erfindungsgemäß einzusetzenden Lotpaste 1, bei denen unterschiedliche Dicken des Lotdepots aufgetragen wurden, wie in Tabelle 2 dargestellt. Wie den Figuren zu entnehmen ist, zeigen die Ergebnisse der Versuche, bei denen die Dicke des Lotdepots in einem Bereich zwischen 100 und 160 µm liegen, sehr gute bis gute Testergebnisse (Fig. 2: Messung der Lotpaste 1 bei 100 µm; Fig. 3: Messung der Lotpaste 1 bei 120 µm; Fig. 4: Messung der Lotpaste 1 bei 160 µm). Obwohl die Lotpaste bei einer Lotdepotdicke von 160 µm (Figur 4) schon recht weit verlaufen ist, kommt es auch hier nicht zu einem unerwünschten Kontakt mit den elektrischen Anschlussstellen des Bauteils, so dass Kurzschlüsse vermieden werden konnten. Eine Schichtdicke, die außerhalb des erfindungsgemäßen Bereichs von 25 bis 200 µm lag, führte dagegen zu Kontakten der Lotpaste mit den elektrischen Anschlussstellen des Bauteils und den dadurch bedingten Kurzschlüssen (Figur 5).

## Patentansprüche

1. Verfahren zur Befestigung eines Bauteils auf einem Substrat umfassend die folgenden Schritte:
i) Bereitstellen eines Bauteils mit einer ersten Oberfläche, wobei das Bauteil mit elektrischen und thermischen Anschlussstellen versehen ist;
ii) Bereitstellen eines Substrates mit einer zweiten Oberfläche, die mit einem Lotdepot versehen ist;
iii) Mechanisches Kontaktieren der ersten Oberfläche des Bauteils mit der zweiten Oberfläche des Substrates über das Lotdepot, wobei die Dicke des Lotdepots 25 bis 200 µm beträgt; und
iv) Erhitzen des Lotdepots über die Liquidustemperatur des Lots,
wobei das Lotdepot durch eine Lotpaste umfassend ein Lot und ein Flussmittel, wobei das Flussmittel eine Dicarbonsäure A und eine Dicarbonsäure B, die voneinander verschieden sind, aufweist, gebildet wird.

2. Verfahren gemäß Anspruch 1, **dadurch gekennzeichnet, dass** die Dicarbonsäure A 5 oder mehr Kohlenstoffatome, vorzugsweise 6 bis 8 Kohlenstoffatome und insbesondere 6 Kohlenstoffatome aufweist.

3. Verfahren gemäß einem oder beiden der Ansprüche 1 und 2, **dadurch gekennzeichnet, dass** Dicarbonsäure B 4 oder weniger Kohlenstoffatome, insbesondere 2 Kohlenstoffatome, aufweist.

4. Verfahren gemäß einem oder mehrerer der Ansprüche 1 bis 3, **dadurch gekennzeichnet, dass** das Gewichtsverhältnis von Dicarbonsäure A zu Dicarbonsäure B 30:1 bis 5:1, vorzugsweise 25:1 bis 7:1, insbesondere 20:1 bis 10:1 beträgt.

5. Verfahren gemäß einem oder mehrerer der Ansprüche 1 bis 4, **dadurch gekennzeichnet, dass** das die Lotpaste folgendes umfasst:
a) 5 bis 15 Gew.-% eines Flussmittel und
b) 85 bis 95 Gew.-% eines Lots,
wobei sich die Gewichtsangaben jeweils auf das Gesamtgewicht der Lotpaste beziehen und wobei das Flussmittel
i) 7 bis 13 Gew.-% Dicarbonsäure A, vorzugsweise Adipinsäure;
ii) 0,3 bis 2,0 Gew.-% Dicarbonsäure B, vorzugsweise Oxalsäure; und
iii) Amin, vorzugsweise ausgewählt aus Aminkomponente X und Aminkomponente Y, wobei Aminkomponente X ein Diamin mit tertiären Aminogruppen ist;
und Aminkomponente Y ein Diamin oder Polyamin ist, bei denen wenigstens 2 der Aminogruppen durch mindestens 3 Kohlenstoffatome voneinander getrennt sind und die wenigstens 4 Kohlenstoffatome aufweisen;
wobei sich die Gewichtsangaben der Dicarbonsäuren jeweils auf das Gesamtgewicht des Flussmittels beziehen.

6. Verfahren gemäß Anspruch 5, **dadurch gekennzeichnet, dass** Aminkomponente X ausgewählt ist aus der Gruppe bestehend aus 1,2-Tetramethylethylendiamin, 1,2-Tetraethylethylendiamin, 1,2-Tetrapropylethylendiamin und 1,2-Tetra-isopropylethylendiamin.

7. Verfahren gemäß Anspruch 5, **dadurch gekennzeichnet, dass** die Aminkomponente Y ausgewählt ist aus der Gruppe bestehend aus N-Coco-1,3-Diaminopropan, 1,6-Diaminohexan, 1,7-Diaminoheptan, 1,8-Diaminooktan, 1,9-Diaminononan und 1,10-Diaminodecan.

8. Verfahren gemäß einem oder mehrerer der Ansprüche 1 bis 7, **dadurch gekennzeichnet, dass** die Gesamtmenge aller Dicarbonsäuren im Flussmittel maximal 15 Gew.-%, vorzugsweise 7 bis 13 Gew.-%, jeweils bezogen auf das Gesamtgewicht des Flussmittels, beträgt.

9. Verfahren gemäß einem oder mehrerer der Ansprüche 1 bis 8, **dadurch gekennzeichnet, dass** das Lot ein Lot auf Zinnbasis ist.

10. Verfahren gemäß einem oder mehrerer der Ansprüche 1 bis 9, **dadurch gekennzeichnet, dass** das Lot Silber in einer Menge von 0,1 bis 8,0 Gew.-%, vorzugsweise 0,2 bis 6 Gew.-% umfasst, bezogen auf das Gesamtgewicht des Lotes.

11. Verfahren gemäß einem oder mehrerer der Ansprüche 1 bis 10, **dadurch gekennzeichnet, dass** das Lot Kupfer in einer Menge von 0,1 bis 1,5 Gew.-%, vorzugsweise 0,2 bis 1,0 Gew.-%, jeweils bezogen auf das Gesamtgewicht des Lots, umfasst.

12. Verfahren gemäß einem oder mehrerer der Ansprüche 1 bis 11, **dadurch gekennzeichnet, dass** das Lot eine Liquidustemperatur im Bereich von 200 bis 250 °C, vorzugsweise im Bereich von 200 bis 230 °C aufweist.

13. Verfahren gemäß einem oder mehrerer der Ansprüche 1 bis 12, **dadurch gekennzeichnet, dass** die Oberfläche des Bauteils mindestens ein Metall umfasst, das ausgewählt ist aus der Gruppe bestehend aus Kupfer, Silber, Gold, Nickel, Aluminium, Zinn und Palladium sowie Legierungen von zwei oder mehrerer der genannten Metalle davon

14. Verfahren gemäß einem oder mehrerer der Ansprüche 1 bis 13, **dadurch gekennzeichnet, dass** die Oberfläche des Substrates mindestens ein Material umfasst, das ausgewählt ist aus der Gruppe bestehend aus Nickel, Gold, Kupfer, Zinn, Silber, Aluminium und Palladium sowie Legierungen von zwei oder mehrerer der genannten Metalle.

15. Bauteil, welches auf einem Substrat befestigt ist, erhältlich gemäß einem Verfahren gemäß einem oder mehreren der Ansprüche 1 bis 14.
